# EUROPÄISCHE PATENTSCHRIFT

(11) **EP 1 390 219 B1**
(45) Veröffentlichungstag und Bekanntmachung des Hinweises auf die Patenterteilung: **22.09.2004**
(21) Anmeldenummer: 02718028.0
(22) Anmeldetag: 17.01.2002
(51) Int. Cl.: B60H 1/00

(54) **ELEKTRISCHE HEIZUNG FÜR EIN KRAFTFAHRZEUG**
ELECTRIC HEATING SYSTEM FOR A MOTOR VEHICLE
CHAUFFAGE ELECTRIQUE POUR VEHICULES

(30) Priorität: 17.01.2001 DE 10102671
(43) Veröffentlichungstag der Anmeldung: 25.02.2004
(73) Patentinhaber: Beru Aktiengesellschaft, 71363 Ludwigsburg (DE); Eichenauer Heizelemente GmbH & Co.KG, 76870 Kandel (DE)
(72) Erfinder: UHL, Günther, 74921 Helmstadt-Bargen (DE); GEIGER, Steffen, 71679 Asperg (DE); ALBAN, Thomas, 74252 Massenbachhausen (DE); GIFFELS, Thomas, 70469 Stuttgart (DE); WENSKE, Dirk, 71636 Ludwigsburg (DE); HAMBURGER, Andreas, 76726 Germersheim (DE); RIETHER, Mike, 76863 Herxheim (DE)
(74) Vertreter: Twelmeier, Ulrich, Dipl.Phys.
(86) Internationale Anmeldenummer: PCT/EP2002/000408
(87) Internationale Veröffentlichungsnummer: WO 2002/057100

(56) Entgegenhaltungen:
- EP-A- 0 682 467
- EP-A- 1 164 816
- DE-A- 10 015 905
- DE-A- 19 848 169
- DE-A- 19 902 050

## Beschreibung

Die Erfindung geht aus von einer elektrischen Heizung für ein Kraftfahrzeug mit den im Oberbegriff des Anspruchs 1 angegebenen Merkmalen. Eine solche Heizung ist als Zusatzheizung zu einem mittels eines Verbrennungsmotors angetriebenen Kraftfahrzeug aus der DE 199 02 050 A1 bekannt. Kfz-Heizungen nutzen in der Regel die Abwärme des Verbrennungsmotors. Durch die fortschreitende Erhöhung des Wirkungsgrades der Verbrennungsmotoren wird die für die Heizung zur Verfügung stehende Abwärme geringer. Das trifft insbesondere auf die besonders kraftstoffsparend ausgebildeten direkteinspritzenden Dieselmotoren zu. Wegen ihrer geringen Abwärme werden diese Motoren vor allem im Winter nicht so schnell warm, wie es wünschenswert ist, um die Frontscheibe zu entfrosten, ein Beschlagen der Frontscheibe zu verhindern und um die Fahrgastzelle auf eine angenehme Temperatur aufzuheizen. Aus diesem Grund ist es aus der DE 199 02 050 A1 bekannt, eine elektrische Zusatzheizung vorzusehen, welche typisch eine Leistung zwischen 250 Watt und 2.000 Watt aufweist. Die bekannte Zusatzheizung verwendet dazu mehrere elektrische Heizstäbe, welche zusammen mit von Wasser durchflossenen Rohren der Hauptheizung des Fahrzeuges zu einem gemeinsamen Wärmetauscher zusammengefaßt sind, welcher seine Wärme an einen in die Fahrgastzelle gerichteten Luftstrom abgibt. Wärmetauscher und elektrische Zuheizer werden aber auch häufig als zwei eigenständige Einheiten verwirklicht.

Die elektrischen Heizstäbe werden mit einem Strom mit einer Stromstärke von typisch 30 A versorgt und zur Regelung ihrer Leistungsabgabe ist eine Steuerschaltung vorgesehen, welche die Leistung der Zusatzheizung mittels eines oder mehrerer Leistungshalbleiter steuert. Die Leistungshalbleiter haben in eingeschaltetem Zustand einen nicht zu vernachlässigenden Widerstand und erzeugen demgemäß eine Verlustwärme, die z.B. in der Größenordnung von je 10 Watt liegt. Die in den Leistungshalbleitem auftretende Verlustwärme muß abgeführt werden, um eine Beschädigung der Steuerschaltung und von in ihrer Nachbarschaft vorhandenen Bauteilen aus Kunststoff zu vermeiden. Die Steuerschaltung mit ihren Leistungshalbleitem und Kühlkörpem sind zu diesem Zweck auf einer Schaltungsträgerplatte angeordnet, welche zusammen mit dem Wärmetauscher zu einer Baueinheit vereinigt ist und in dem Luftstrom liegt, welcher den Wärmetauscher durchströmt. Nachteilig dabei ist, daß die im Luftstrom liegende Steuerschaltung nicht vor Umwelteinflüssen geschützt und die elektrische Sicherheit nicht gewährleistet ist, zumal der Luftstrom eine hohe Feuchte aufweisen kann, die sich zeitweise auf der Steuerschaltung niederschlagen kann.

Der vorliegenden Erfindung liegt die **Aufgabe** zugrunde, einen Weg aufzuzeigen, wie bei einer elektrischen Heizung für ein Kraftfahrzeug der Schutz der Steuerschaltung und die elektrische Sicherheit verbessert werden können und gleichzeitig die Verlustwärme aus der Steuerschaltung wirkungsvoll abgeführt werden kann, ohne den Aufbau der Zusatzheizung wesentlich zu komplizieren.

Diese Aufgabe, deren Ziele einander teilweise ausschließen, wird durch eine elektrische Heizung mit den im Anspruch 1 angegebenen Merkmalen gelöst. Vorteilhafte Weiterbildungen der Erfindung sind Gegenstand der Unteransprüche.

Ein grundsätzliches Problem bei der Lösung der gestellten Aufgabe ist dadurch gegeben, daß die wärmeabgebenden Montageflächen der Leistungshalbleiter, welche den Strom für die Heizelemente führen und schalten, auf Plus-Potential liegen, wohingegen die Kühlkörper aus Sicherheitsgründen auf Massepotential liegen sollen. Als Leistungshalbleiter kommen vor allem MOSFETs infrage, welche bevorzugt in einem Verfahren der Pulsweiten-Modulation betrieben werden. Das Abführen der Verlustwärme aus den Leistungshalbleitern ist deshalb unter den widersprüchlichen Randbedingungen durchzuführen, daß eine gute thermische Kopplung bei gleichzeitiger elektrischer Isolierung zu erreichen ist. Die Lösung der Aufgabe wird weiterhin dadurch erschwert, daß die wärmeabgebende Fläche der Leistungshalbleiter in der Regel der Schaltungsträgerplatte zugewandt und mit dieser verlötet ist.

Man könnte daran denken, spezielle Schaltungsträgerplatten zu verwenden, bei denen auf ein Blech eine Isolierschicht und darauf eine Kupferschicht aufgebracht sind, wobei die Kupferschicht durch Ätzen strukturiert werden kann. Derartige Leiterplatten sind aber sehr teuer, vor allem wenn eine zweilagige Leiterptatte auf dem Blech zu erzeugen ist.

Erfindungsgemäß wird nun vorgeschlagen, die in den Leistungshalbleitern auftretende Verlustwärme durch die Schaltungsträgerplatte hindurch auf ihre Unterseite zu übertragen und dort in eine Metallplatte einzuleiten, welche stoffschlüssig mit der Unterseite der Schaltungsträgerplatte verbunden ist. Die Metallplatte soll auf Massepotential liegen und ist deshalb gegenüber Leiterbahnen, welche sich auf der Unterseite der Schaltungsträgerplatte befinden und eine Spannung führen können, elektrisch isoliert. Die Isolierung kann durch den Stoff erfolgen, welcher die Metallplatte und die Schaltungsträgerplatte stoffschlüssig miteinander verbindet. Die stoffschlüssige Verbindung sorgt für eine unter der gegebenen Voraussetzung einer elektrischen Isolierung optimale Übertragung der Verlustwärme von der Schaltungsträgerplatte auf die Metallplatte, welche eine vargleichsweise hohe Wärmekapazität hat und deshalb eine den Wärmeabfluß fördernde Wärmesenke bildet, in welche die Verlustwärme auf dem kürzest möglichen Weg von der Bestückungsseite der Schaltungsträgerplatte durch die Schaltungsträgerplatte hindurch fließen kann. Von dieser Wärmesenke wird die Wärme dann mit Hilfe eines oder mehrerer wärmeleitender Verbinder in einen oder mehrere Kühlkörper abgeleitet, welche in einiger Entfernung von der Steuerschaltung angeordnet sein können, so daß sie durch einen Luftstrom gekühlt werden können, welcher die Steuerschaltung selbst jedoch nicht erreicht. Die Steuerschaltung kann vielmehr gut geschützt in einem Gehäuse angeordnet sein, in welchem sich auch die Metallplatte befindet und aus welchem der oder die wärmeleitenden Verbinder herausführen. Die Wärmeabfuhr erfolgt also zweistufig, indem die Verlustwärme der Leistungshalbleiter zunächst von der Metallplatte aufgesogen und dann von dieser über wärmeableitende Verbinder an außenliegende Kühlkörper abgegeben wird.

Die Erfindung hat wesentliche Vorteile:
◆ Die Erwärmung der Steuerschaltung wird hinreichend begrenzt.
◆ Gleichzeitig kann die Steuerschaltung geschützt in einem Gehäuse untergebracht sein, in welches der kühlende Luftstrom nicht eintreten muß.
◆ Die Verwendung einer Metallplatte als einer mit der Schaltungsträgerplatte stoffschlüssig verbundenen Wärmesenke stellt eine fertigungsmäßig und kostenmäßig günstige Lösung dar.
◆ Die Verwendung einer stoffschlüssig mit der Schaltungsträgerplatte verbundenen Metallplatte eröffnet, wie noch gezeigt wird, Möglichkeiten für einen kostensparenden Aufbau und eine kostensparende Montage der elektrischen Heizung.

Die Metallplatte besteht vorzugsweise aus einem die Wärme gut leitenden Metall, insbesondere aus Aluminium oder aus Kupfer oder aus Legierungen dieser Metalle, um die zugeführte Wärme leicht aufnehmen, spreizen und wieder abführen zu können. Eine Metallplatte in einer Dicke von ungefähr 1 mm ist gut geeignet.

Die stoffschlüssige Verbindung zwischen der Metallplatte und der Schaltungsträgerplatte wird vorzugsweise dadurch verwirklicht, daß man die beiden miteinander verklebt. Elektrisch isolierende Klebstoffe mit verhältnismäßig hoher Wärmeleitfähigkeit sind an sich bekannt. Die Wärmeleitfähigkeit der Klebstoffschicht beträgt vorzugsweise mindestens 0,6 W/(m x K), noch besser mindestens 0,9 W/(m x K). Besonders geeignet ist ein Klebstoff auf der Grundlage eines vemetzenden Zweikomponenten-Silikonelastomers, welches eine hohe Wärmeleitfähigkeit von mehr als 0,9 W/(m x K) mit einer die Verbindung auch unter den hohen Rüttelbeanspruchungen im Kraftfahrzeug gewährleistenden Dauerelastizität verbindet. Die elektrisch isolierende Wirkung der Verklebung kann erforderlichenfalls ergänzt werden durch einen dünnen Kunstharzlack auf der der Schaltungsträgerplatte zugewandten Seite der Metallplatte oder durch eine dünne Oxidschicht, welche zumal bei Aluminium anodisch verstärkt sein kann.

Da die Schicht, welche die Metallplatte und die Schaltungsträgerplatte stoffschlüssig verbindet, die Wärme von der Schaltungsträgerplatte auf die Metallplatte übertragen soll, sollte darauf geachtet werden, daß diese Schicht möglichst dünn und porenfrei ist. Vorzugsweise ist die Schicht höchstens 0,2 mm dick, noch besser höchstens 0,15 mm. Dabei ist zu berücksichtigen, daß die Schichtdicke wegen der auf der Unterseite der Schaltungsträgerplatte vorhandenen Leiterbahnen deren Höhe nicht unterschreiten kann, welche je nach der zu führenden Stromstärke, bis zu 140 µm betragen kann.

Vorzugsweise sind zwischen der Metallplatte und der Schaltungsträgerplatte starre Abstandhalter vorgesehen, welche einen gleichmäßig niedrigen Abstand zwischen der Metallplatte und der Schaltungsträgerplatte gewährleisten und ein Mittel sind, um die Dicke der elektrisch isolierenden Schicht zu minimieren und den Wärmeübergang zu maximieren. Die Abstandhalter könnten dünne Scheiben sein, welche mit der Metallplatte und/oder mit der Schaltungsträgerplatte verklebt werden. Günstiger ist es jedoch, wenn die Abstandhalter Höcker sind, welche die Metallplatte an Stellen aufweist, welchen auf der Unterseite der Schaltungsträgerplatte keine Leiterbahn gegenüberliegt. Solche Abstandhalter können am einfachsten durch Prägen der Metallplatte gebildet sein. In bevorzugter Weiterbildung der Erfindung kann der eine oder andere Höcker der Metallplatte aber auch eine elektrisch leitende Verbindung mit einer solchen Leitungsbahn der Schaltungsträgerplatte herstellen, welche auf Massepotential liegt, so daß definierte und sichere Potentialverhältnisse hergestellt werden.

Die Größe der Metallplatte ist vorzugsweise so gewählt, daß sie ungefähr so groß ist wie die Schaltungsträgerplatte und annähernd die gleiche Umrißgestalt wie diese hat. Man erhält dadurch eine sandwichartige Baugruppe, die im Gehäuse der Steuerschaltung günstig zu montieren ist.

Bei einem Leistungshalbleiter, dessen wärmeabgebende Fläche eine der Schaltungsträgerplatte zugewandte und mit ihr verlötete elektrische Kontaktfläche ist (sie liegt bei einem MOSFET regelmäßig auf Plus-Potential), ist es für Zwecke der Erfindung günstig, wenn die Schaltungsträgerplatte an den Stellen, an welchen die Leistungshalbleiter angeordnet sind, eine hohe Dichte von Strompfaden aufweist, welche von der Bestückungsseite der Schaltungsträgerplatte durch diese hindurch bis auf deren Unterseite führen, denn das steigert die Wärmeleitfä higkeit durch die Schaltungsträgerplatte hindurch im Bereich unter den Leistungshalbleitern beträchtlich; die Verlustwärme kann die Schaltungsträgerplatte auf kürzestem Wege auf den gut leitenden Pfaden durchqueren und muß dann nur noch die dünne Klebstoffschicht durchqueren, um in die Metallplatte zu gelangen. Die Strompfade können dadurch hergestellt werden, daß die Schaltungsträgerplatte in den genannten Bereichen mehrfach durchbohrt wird und die Bohrungen metallisiert und schließlich mit Metall gefüllt werden, z.B. durch galvanische Verkupferung oder durch Verzinnen von zuvor galvanisch metallisierten Bohrungen.

Vorzugsweise sind die Bereiche, in welchen die die Schaltungsträgerplatte durchquerenden Strompfade angeordnet sind, jeweils annähernd so groß wie die Grundfläche des jeweiligen Leistungshalbleiters. Weiterhin ist es bevorzugt, die für jeweils einen Leistungshalbleiter vorgesehenen Strompfade dadurch zusammenzufassen, daß man die Strompfade auf der Bestückungsseite und auch auf der Unterseite der Schaltungsträgerplatte in Metallflächen enden läßt, deren Größe jeweils annähernd mit der Grundfläche des Leistungshalbleiters übereinstimmt.

Die in die Metallplatte eingeleitete Verlustwärme muß von dieser auch wieder abgeleitet werden, wozu sie durch einen oder mehrere wärmeleitende Verbinder mit einem oder mehreren Kühlkörpern verbunden ist. Die wärmeleitenden Verbinder könnten durch Löten oder Schweißen einerseits mit der Metallplatte und andererseits mit den Kühlkörpern verbunden sein. Vorzugsweise sind sie jedoch steckbar miteinander verbunden, was die Montage und die Demontage zu Wartungszwekken erleichtert und Fertigungskosten senkt.

Grundsätzlich könnte der jeweilige Verbinder flexibel sein, z.B, eine Litze. Dann müßten die Kühlkörper und die Steuerschaltung gesondert an tragenden Strukturen befestigt werden. Deshalb ist es bevorzugt, die Verbinder starr auszubilden, vorzugsweise als Stab oder Hohlstab. Die Steuerschaltung und ihre externen, über Verbinder angekoppelten Kühlkörper bilden dann, selbst wenn sie lösbar zusammengesteckt sind, eine Baugruppe, welche einheitlich, durch gemeinsame Befestigungsmittel, im Kraftfahrzeug montiert werden kann.

Zur Verbindung zwischen der Metallplatte und den starren Verbindern können aus der Metallplatte einander paarweise gegenüberliegende Zungen ausgeschnitten und aus der Ebene der Metallplatte weggebogen sein. Ist der gegenseitige Abstand der Zungen kleiner als die Dicke des starren Verbinders, dann kann dieser klemmend zwischen ein solches Paar Zungen eingeführt werden, wobei durch die Richtung, in welcher die Zungen gebogen sind, ein Zurückziehen der Verbinder aus den Zungen heraus in erwünschter Weise gehemmt werden kann.

Die. Kühlkörper sind vorzugsweise Bleche. Vorzugsweise sind mehrere Kühlkörper und mehrere, zweckmäßigerweise zueinander parallele Verbinder vorgesehen, wobei die Kühlkörper auf die Verbinder aufgeschoben sind, so daß sich die Kühlkörper und die Verbinder gegenseitig verbinden und in ihrer gegenseitigen Lage stabilisieren, wodurch eine handhabbare, hinreichend steife Struktur entsteht. Die Kühlkörper (Bleche) könnten mit den Verbindern verlötet oder verschweißt werden; da sie jedoch keine hohen Kräfte aufzunehmen haben, genügt es aber, die Kühlkörper kraftschlüssig, durch Klemmung, auf den Verbindern festzulegen.

Die Länge der Verbinder wird so bemessen, daß im Hinblick auf den vorgesehenen Einbauort für die Steuerschaltung die Kühlkörper in einem für ihre Kühlung vorgesehenen Strömungsweg der Luft liegen, vorzugsweise in jenem Strömungsweg der Luft, in welchem auch die Wärmeabgabeeinrichtungen der elektrischen Heizung des Kraftfahrzeuges liegt. Vorzugsweise liegen die Kühlkörper in der Nachbarschaft der Wärmeabgabeeinrichtungen der elektrischen Heizung, insbesondere zwischen diesen und dem Gehäuse der Steuerelektronik, aber mit Abstand von diesem Gehäuse.

Ein besonders kostengünstiger und kompakter Aufbau der Heizung ergibt sich dadurch, daß die Heizelemente in Heizstäben enthalten sind, weiche zugleich als die Verbinder zwischen der Metallplatte und den Kühlkörpem dienen, so daß auf den Heizstäben nicht nur die Wärmeabgabeeinrichtungen der elektrischen Heizung, sondern auch die Kühlkörper angebracht sind. Es ist aber auch möglich, die Heizstäbe der elektrischen Heizung und die Verbinder zwischen der Metallplatte der Steuerschaltung und deren Kühlkörpem konstruktiv zu trennen. Nutzt man jedoch die Heizstäbe zugleich als Träger für die Kühlkörper, eröffnet sich die Möglichkeit, die Heizstäbe mit ihren Wärmeabgabeeinrichtungen, die Kühlkörper und das Gehäuse mit der Steuerschaltung zu einer kompakten Baueinheit zusammenzufassen, wobei einerseits die Steuerschaltung mit ihrem Gehäuse und andererseits die Heizstäbe mit ihren Wärmeabgabeeinrichtungen und mit ihren Kühlkörpem durch bloße Steckverbindungen sowohl elektrisch als auch mechanisch hinreichend steif und fest miteinander verbunden werden können, was durch die Verwendung der Metallplatte an der Unterseite der Schaltungsträgerplatte wesentlich erleichtert wird, denn sie bildet eine mechanisch stabile Basis, um die Steuerschaltung an den Heizstäben anzubringen, welche zugleich die Verbinder zwischen der Metallplatte und den Kühlkörpem der Steuerschaltung sind. Das Anbringen der Steuerschaltung an den Heizstäben kann insbesondere so erfolgen, daß die Heizstäbe zwischen paarweise ausgeschnittene und hochgestellte Zungen eingeführt werden, welche auf die Heizstäbe klemmend und führend einwirken. Die danach auf der Schaltungsträgerplatte noch herzustellende elektrische Verbindung zwischen den Heizelementen und der Steuerschaltung benötigt keine besondere mechanische Tragfähigkeit, da diese bereits durch die mit Hilfe der Metallplatte erzielte Steckverbindung erreicht wird.

Sowohl die auf der Schaltungsträger ausgebildeten elektrischen Steckverbinder als auch die auf der Metallplatte ausgebildeten mechanischen Steckverbinder für die Heizstäbe sind vorzugsweise so ausgebildet, daß ihre Steckrichtung mit der Längsrichtung der Heizstäbe übereinstimmt. Das erleichtert das Zusammenstekken und Trennen der Heizstäbe und ihrer Steuerschaltung. Während der mechanische Steckverbinder auf der der Schaltungsträgerplatte abgewandten Seite der Metallplatte ausgebildet sein sollte, sollte der elektrische Steckverbinder für die Heizstäbe vorzugsweise auf der der Metallplatte abgewandten Seite der Schaltungsträgerplatte angeordnet und durch übereinanderliegende Löcher in der Metallplatte und in der Schaltungsträgerplatte hindurch für die in den jeweiligen Heizstab hineinführende elektrische Zuleitung zugänglich sein.

Außerdem kann die Metallplatte dazu herangezogen werden, einen Kontaktstift oder Kontaktbolzen zu tragen, über welchen der Masseanschluß der Steuerschaltung hergestellt werden kann. Er kann mit der Metallplatte verlötet, verschweißt, vernietet oder eingepreßt sein und kann erhebliche Kräfte aufnehmen. Der Pluspol der Steuerschaltung wird demgegenüber bevorzugt auf der Schaltungsträgerplatte befestigt und kann ebenfalls ein tragfähiger Stift oder Bolzen sein, da die Schaltungsträgerplatte durch ihre Verbindung mit der metallischen Platte an Tragfähigkeit und Belastbarkeit gewonnen hat.

Am günstigsten und für die Fertigung am preiswertesten ist es, wenn die Wärmeabgabeeinrichtungen und die Kühlkörper ähnlich oder übereinstimmend ausgebildet sind, insbesondere in Form von Lamellen aus Blech, aus welchen Zungen ausgeschnitten sind, welche einander paarweise oder kranzförmig gegenüberliegen und ein kraftschlüssiges, klemmendes Aufschieben der Lamellen auf die Heizstäbe ermöglichen. Die auf den Heizstäben angeordneten Wärmeabgabeeinrichtungen und Kühlkörper erfüllen eine doppelte Funktion, indem sie sowohl von den Heizelementen kommende Wärme als auch von den Leistungshalbleitem kommende Wärme abgeben. Dabei ist es bevorzugt, um die Abgabe der von den Leistungshalbleitern kommenden Wärme zu optimieren, daß die Heizstäbe in einem an das Gehäuse der Steuerschaltung anschließenden Abschnitt noch keine Heizelemente enthalten, wohl aber Kühlkörper tragen, welche die Verlustwärme der Leistungshalbleiter aufnehmen.

Um den Weg der Verlustwärme von den Leistungshalbleitern zu ihren Kühlkörpem gering zu halten, wird bevorzugt, daß die Verbinder von einer Stelle der Metallplatte ausgehen, welche nahe bei den Leistungshalbleitem liegt.

Der weiteren Erläuterung der Erfindung dienen die beigefügten schematischen Zeichnungen. Gleiche oder einander entsprechende Teile sind in den einzelnen Zeichnungen mit übereinstimmenden Bezugszahlen bezeichnet.

Es zeigen:
- Figur 1: Heizelemente mitsamt Heizstäben und Wärmeabgabeeinrichtungen einer elektrischen Heizung eines Kraftfahrzeuges,
- Figur 2: einen Ausschnitt eines Querschnitts einer elektrischen Heizung eines Kraftfahrzeuges,
- Figur 3: den Anschluß der Heizstäbe an die Steuerschaltung,
- Figur 4a: einen Ausschnitt von Schaltungsträgerplatte und Metallplatte, und
- Figur 4b: eine alternative Ausgestaltung des in Figur 4a gezeigten Ausschnitts der Schaltungsträgerplatte.

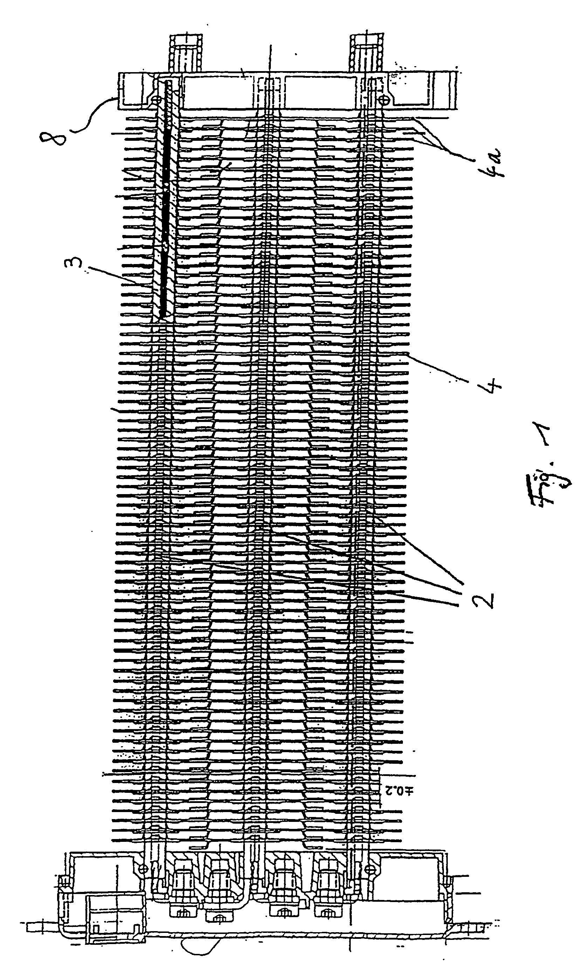

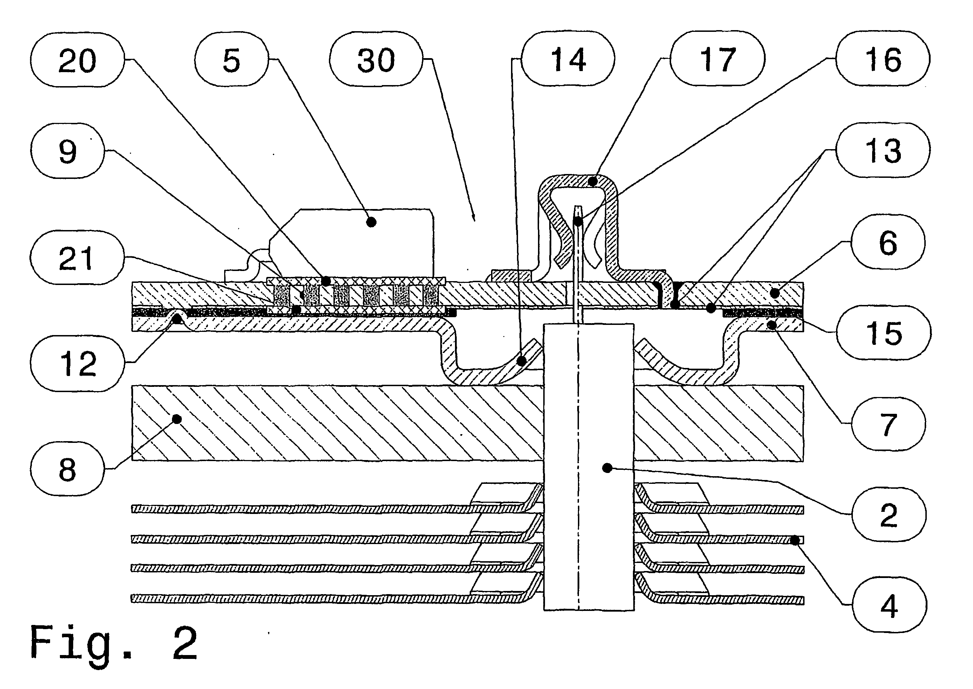

Figur 1 zeigt die Heizstäbe 2, welche mit PTC-Heizelementen 3 gefüllt sind, sowie die zugehörigen Wärmeabgabeeinrichtungen 4; welche als lamellenförmige Bleche auf die Heizstäbe 2 klemmend aufgeschoben sind, für ein Ausführungsbeispiel einer elektrischen Heizung eines Kraftfahrzeuges. Im Betrieb der elektrischen Heizung werden die Heizstäbe 2 und die zugehörigen Wärmeeinrichtungen 4 von einem zu erwärmenden Luftstrom umströmt und geben dabei Wärme an den Luftstrom ab. Vorteilhaft wird dabei nicht nur die von den PTC-Heizelementen 3 erzeugte Wärme, sondern auch von den Bauteilen einer im Gehäuse 8 vorgesehenen Steuerschaltung 30 an den Luftstrom abgegeben. Dadurch wird nicht nur eine Überhitzung der im Gehäuse 8 vorgesehenen Steuerschaltung vermieden, sondern auch die Effizienz der elektrischen Heizung verbessert. Die Wärmeabgabeeinrichtungen 4a dienen der Abfuhr der von den Bauteilen der im Gehäuse 8 vorgesehenen Steuerschaltung 30, welche ausschnittsweise in Figur 2 dargestellt ist, erzeugten Wärme. Im Bereich der Wärmeabgabeeinrichtungen 4a enthalten die Heizstäbe 2 keine Heizelemente 3. Auf diese Art und Weise läßt sich die Wärme, welche die im Gehäuse 8 vorgesehene Steuerschaltung 30 erzeugt, über die Wärmeabgabeeinrichtungen 4a effizient abführen.

Figur 2 zeigt beispielhaft in einem Ausschnitt eines Querschnittes durch das Gehäuse 8, wie die Heizstäbe 2 mechanisch und wärmeleitend mit der Steuerschaltung 30 verbunden sind. Die im Gehäuse 8 angeordnete Steuerschaltung 30 weist für jeden Heizstab 2 einen diesem zugeordneten Leistungshalbleiter 5 auf, welche auf einer Schaltungsträgerplatte 6 angeordnet sind. Die Steuerschaltung 30 steuert mittels der Leistungshalbleiter 5 die in den Heizstäben 2 freigesetzte Leistung. Dabei werden die Leistungshalbleiter 5 durch den durch sie fließenden Strom ebenfalls erwärmt.

Im folgenden wird erläutert, wie die Leistungshalbleiter 5 elektrisch mit den Heizstäben 2 verbunden sind und wie eine effiziente Wärmeabfuhr der von den Leistungshalbleitem 5 erzeugten Wärme erreicht wird. Die Schaltungsträgerplatte 6 ist an ihrer Unterseite stoffschlüssig mit einer Metallplatte 7 mittels einer Klebschicht 15 verbunden. Die Metallplatte 7 ist dazu vorgesehen, auf Massepotential zu liegen und leitend mit den Heizstäben 2 verbunden. Sie ist durch die Klebeschicht 15 gegenüber den Leiterbahnen 13, welche sich auf der Unterseite der Schaltungsträgerplatte 6 befinden und dazu vorgesehen sind, gegenüber dem Massepotential eine Spannung zu führen, elektrisch isoliert. Die Steuerschaitung 30 mitsamt der Schaltungsträgerplatte 6 und der Metallplatte 7 befinden sich in dem Gehäuse 8, so daß die Steuerschaltung 30 vor Feuchtigkeit geschützt ist. Die von den Leistungshalbleitern 5 erzeugte Wärme wird durch die Schaltungsträgerplatte 6 hindurch zur Metallplatte 7 und von dort mittels des Heizstabes 2 als wärmeleitenden Verbinders aus dem Gehäuse 8 abgeführt und schließlich von den Wärmeabgabeeinrichtungen 4a abgegeben. Den Heizstab 2 als wärmeleitenden Verbinder von der Metallplatte 7 an den Wärmeabgabeeinrichtungen 4a auszuführen ist nicht unbedingt erforderlich, führt jedoch vorteilhaft zu einer kompakten Heizung. Selbstverständlich läßt sich aber auch zwischen der Metallplatte 7 und den Wärmeabgabeeinrichtungen 4a oder dem Heizstab 2 ein separater wärmeleitender Verbinder vorsehen.

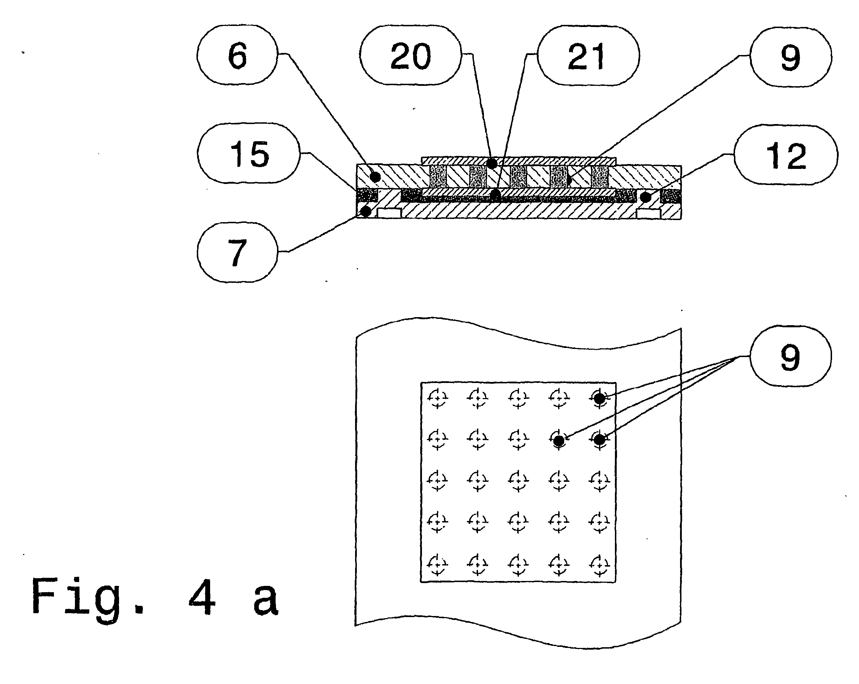

Um die Abfuhr der von den Leistungshalbleitern 5 erzeugten Wärme durch die Schaltungsträgerplatte 6 hindurch zu unterstützen, weist die Schaltungsträgerplatte 6 an den Stellen, an welchen die Leistungshalbleiter 5 angeordnet sind, eine hohe Dichte von Strompfaden 9 auf, welche neben dem elektrischen Strom auch die Wärme leiten und von der Oberseite der Schaltungsträgerplatte 6 durch die Schaltungsträgerplatte 6 hindurch bis auf deren Unterseite führen. Bei diesen Strompfaden 9 handelt es sich um Bohrungen welche mit Lötzinn gefüllt sind. Die Abfuhr der Wärme von der Unterseite der Schaltungsträgerplatte 6 auf die Metallplatte 7 erfolgt durch eine möglichst dünn ausgebildete Klebeschicht 15 eines Wärmeleitklebers, weicher bevorzugt ein vemetzendes Zweikomponenten-Silikonelastomer ist und eine Wärmeleitfähigkeit von über 0,9 W/(m x K) aufweist. Um das Verkleben der Metallplatte 7 mit der Schaltungsträgerplatte 6 zu erleichtern, weist die Metallplatte 7, wie insbesondere in Figur 4a gezeigt, mehrere Abstandhalter 12 auf, welche in Form kleiner Höcker auf die Metallplatte 7 aufgeprägt sind. Der Klebstoff wird zwischen den Abstandhaltern 12 aufgetragen und weicht beim Zusammenfügen von Metallplatte 7 und Schaltungsträgerplatte 6 zur Seite aus, so daß sich eine porenfreie Klebeschicht 15 mit guter Wärmeleitfähigkeit ausbildet. Eine weitere Funktion eines Teils dieser Abstandhalter 12 besteht darin, eine elektrische Masseverbindung zwischen der Metallplatte 7 und einer Leiterbahn 13 der Schaltungsträgerplatte 6, welche auf Massepotential liegen soll, herzustellen. Jene Abstandhalter 12, welche nicht dem Zweck dienen, eine elektrische Masseverbindung mit einer Leiterbahn 13 der Schäitungsträgerplatte 6 herzustellen, befinden sich an Stellen der Metallplatte 7, weichen auf der Unterseite der Schaltungsträgerplatte 6 keine Leiterbahn 13 gegenüberliegt.

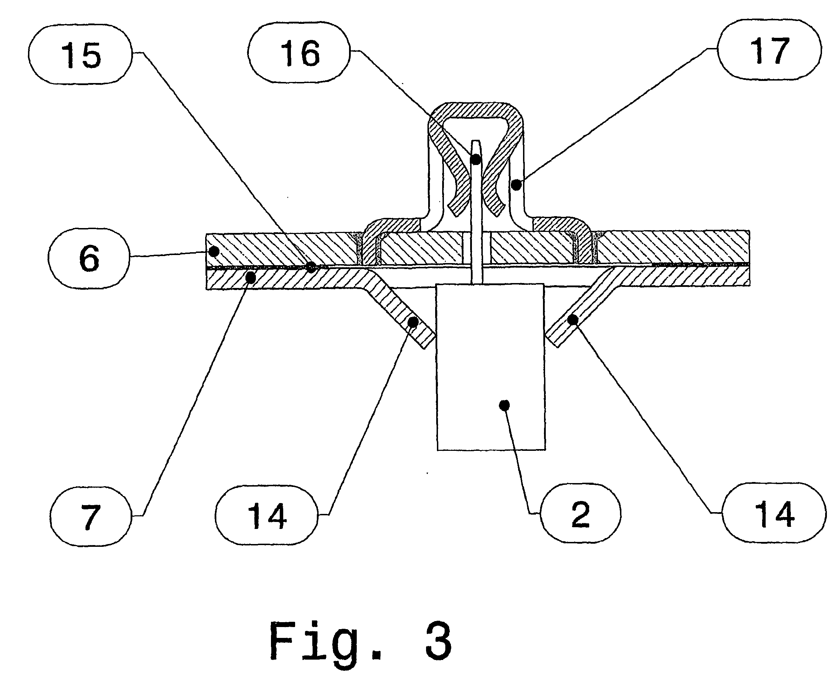

Die Metallplatte 7, welche an der Unterseite der Schaltungsträgerplatte 6 angebracht ist, ist bevorzugt annähernd so groß und von gleicher Umrißgestalt wie die Schaltungsträgerplatte 6. Auf diese Art wird eine kompakte und mechanisch stabile Baugruppe gebildet, welche sich zum Verbinden mit den Heizstäben 2 gut handhaben läßt. Die Metallplatte 7 - und damit über die mit ihr stoffschlüssig verbundene Schaltungsträgerplatte 6 auch die Steuerschaltung 30 - ist lösbar durch eine Steckverbindung mit dem als Verbinder genutzten Heizstab 2. Vorteilhaft kann so im Falle eines Defektes der Steuerschaltung 30 diese mit allen im Gehäuse 8 befindlichen zugehörigen Teilen leicht ausgetauscht werden. Aus der Metaltplatte 7 sind zu diesem Zweck einander paarweise gegenüberliegende Zungen 14 ausgeschnitten und, wie auch in Figur 3 gezeigt, aus der Ebene der Metallplatte 7 weggebogen. Der gegenseitige Abstand der Zungen 14 ist dabei kleiner als die Dicke des starren als Verbinder genutzten Heizstabes 2, welcher zwischen ein solches Paar Zungen 14 einführbar ist. Die in Figur 3 gezeigte Ausführungsform ermöglicht einen besonders günstigen engen Kontakt von Metallplatte 7 und Schaltungsträgerplatte 6. Figur 2 zeigt eine weitere Ausführungsform, bei welcher die Zungen 14 an ihrem dem Heizstab 2 zugewandten Ende zur Metallplatte 7 hingebogen sind, was das klemmende Aufschieben auf die als Verbinder ausgebildeten Heizstäbe 2 erleichtert.

Figur 3 zeigt neben der mechanischen Verbindung des Verbinders 2 mit der Metallplatte 7, auch den elektrischen Anschluß an die Schaltungsträgerplatte 6. Der als Verbinder ausgebildete Heizstab 2 ist über die klemmend anliegenden Zungen 14 elektrisch mit der Metallplatte 7 verbunden und liegt somit, wie diese, auf Massepotential.

Die spannungsführenden Leiterbahnen 13 der Schaltungsträgerplatte 6 sind über einen auf der Schaltungsträgerplatte 6 angebrachten Steckverbinder 17 mit der spannungsführenden Zuleitung 16 der Heizelemente 3 im Inneren der Heizstäbe 2 verbunden.

Figur 4a zeigt im Detail die Strompfade 9, welche in Form von mit Lötzinn gefüllten Bohrungen durch die Schaltungsträgerplatte 6 hindurchgehen, sowie den gegenüberliegenden Abschnitt der Metallplatte 7, auf welchen die höckerförmigen Abstandhalter 12 aufgeprägt sind. Jener Bereich der Schaltungsträgerplatte 6, welcher die Strompfade 9 vorsieht, dient zum Anbringen eines Leistungshalbleiters 5 und weist wegen der Lötzinn gefüllten Bohrungen vorteilhaft eine erhöhte Wärmeleitfähigkeit auf. Zur weiteren Verbesserung der Wärmeabfuhr weist die Schaltungsträgerplatte 6 im Bereich der Strompfade 9 an ihrer Oberseite eine Metallfläche 20 und an ihrer Unterseite eine Metallfläche 21 auf, welche durch die Strompfade 9 verbunden sind, wobei die Metallflächen 20, 21 annähernd so groß sind wie die Grundfläche des jeweiligen Leistungshalbleiters 5, welcher auf der Metallfläche 20 angeordnet ist. Im Extremfall lassen sich die Bohrungen selbstverständlich auch so groß ausführen, daß sie der Grundfläche des jeweiligen Leistungshalbleiters 5 entsprechen.

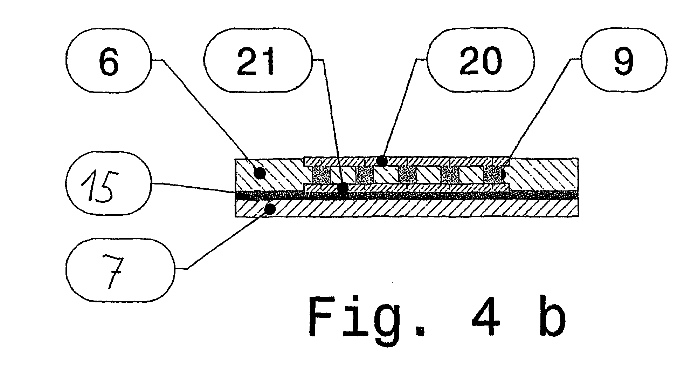

Figur 4b zeigt eine alternative Ausgestaltung des in Figur 4a gezeigten Ausschnitts der Schaltungsträgerplatte 6 im Bereich der Strompfade 9. Im Unterschied zu dem in Figur 4a gezeigten Ausführungsbeispiel sind bei dem in Figur 4b gezeigten Ausführungsbeispiel die Metallflächen 20 und 21 an der Oberseite und der Unterseite der Schaltungsträgerplatte 6 in der Schaltungsträgerplatte 6 versenkt angeordnet. Durch diese Maßnahme werden die Strompfade 9 verkürzt und somit die Wärmeabfuhr der von einem auf der Metallfläche 20 anzuordnenden Leistungshalbleiter 5 (siehe Figur 2) erzeugten Wärme verbessert.

Das in Figur 4b gezeigte Ausführungsbeispiel unterscheidet sich von dem in Figur 4a gezeigten Ausführungsbeispiel im weiteren dadurch, daß auf die in Figur 4a gezeigten, auf die Metallplatte 7 aufgeprägt Abstandhalter 12 verzichtet wurde. Ein wohl definierter Abstand zwischen der Metallplatte 7 und der Schaltungsträgerplatte 6 wird bei dem in Figur 4b gezeigten Ausführungsbeispiel mittels dem Klebstoff zugesetzten Partikeln, beispielsweise aus Glas oder Keramik, von definiertem Durchmesser gewährleistet. Derartige Partikel, welche bevorzugt kugelförmig sind, sind dem die Klebstoffschicht 15 ausbildenden Klebstoff zugemischt und gewährleisten, daß beim Zusammenkleben der Metallplatte 7 mit der Schaltungsträgerplatte 6 ein definierter Abstand, welcher dem Durchmesser der Partikel entspricht, eingehalten wird. Eine elektrische Masseverbindung zwischen der Metallplatte 7 und einer Leiterbahn 13 der Schaltungsträgerplatte 6, welche auf Massepotential liegen soll, läßt sich in diesem Fall beispielsweise durch Kontaktierung einer Leiterbahn 13 mit dem in Figur 3 gezeigten Steckverbinder 17 erreichen.

## Patentansprüche

1. Elektrische Heizung für Kraftfahrzeuge mit folgenden Merkmalen:
◆ Die Heizung hat ein oder mehrere elektrische Heizelemente (3);
◆ zum Steuern der von den Heizelementen (3) abgegebenen Leistung ist eine Steuerschaltung vorgesehen, **dadurch gekennzeichnet, daß**
◆ die Steuerschaltung einen oder mehrere Leistungshalbleiter (5) umfaßt, welche auf einer Schaltungsträgerplatte (6) angeordnet sind;
◆ die Schaltungsträgerplatte (6) auf ihrer den Leistungshalbleitem (5) abgewandten Seite (nachfolgend als ihre Unterseite bezeichnet) stoffschlüssig mit einer Metallplatte (7) verbunden ist, welche dazu vorgesehen ist, auf Massepotential zu liegen
◆ die Metallplatte (7) gegenüber Leiterbahnen, welche sich auf der Unterseite der Schaltungsträgerplatte (6) befinden und dazu vorgesehen sind, gegenüber dem Massepotential eine Spannung zu führen, elektrisch isoliert ist;
◆ die Steuerschaltung sich in einem Gehäuse (8) befindet;
◆ außerhalb des Gehäuses (8) ein oder mehrere Kühlkörper (4a) vorgesehen sind;
◆ wärmeleitende Verbinder (2) die im Gehäuse (8) liegende metallische Platte (7) mit den außerhalb des Gehäuses (8) liegenden Kühlkörpern (4a) verbinden.

2. Heizung nach Anspruch 1, **dadurch gekennzeichnet, daß** die Metallplatte (7) aus einem die Wärme gut leitenden Metall besteht, insbesondere aus Aluminium oder Kupfer oder aus Legierungen dieser Metalle.

3. Heizung nach Anspruch 1 oder 2, **dadurch gekennzeichnet, daß** die Metallplatte (7) auf ihrer der Schaltungsträgerplatte (6) zugewandten Seite eine dünne, elektrisch isolierende Schicht trägt, insbesondere einen Kunstharzlack oder eine Oxidschicht, welche vorzugsweise anodisch verstärkt ist.

4. Heizung nach einem der vorstehenden Ansprüche, **dadurch gekennzeichnet, daß** die Metallplatte (7) mit der Schaltungsträgerplatte (6) verklebt ist.

5. Heizung nach Anspruch 4, **dadurch gekennzeichnet, daß** die zwischen der Metallplatte (7) und der Schaltungsträgerplatte (6) vorgesehene Klebstoffschicht (15) eine Wärmeleitfähigkeit von mindestens 0,6 W/(m x K), vorzugsweise von mindestens 0,9 W/(m x K) aufweist.

6. Heizung nach Anspruch 4 oder 5, **dadurch gekennzeichnet, daß** der Klebstoff ein vemetzendes Zweikomponenten-Silikonelastomer ist.

7. Heizung nach einem der vorstehenden Ansprüche, **dadurch gekennzeichnet, daß** die metallische Platte (7) annähernd so groß ist wie die Schaltungsträgerplatte (6).

8. Heizung nach einem der vorstehenden Ansprüche, **dadurch gekennzeichnet, daß** die metallische Platte (7) annähernd die gleiche Umrißgestalt wie die Schaltungsträgerplatte (6) hat.

9. Heizung nach einem der vorstehenden Ansprüche, **dadurch gekennzeichnet, daß** die Klebstoffschicht (15) höchstens 0,2 mm dick ist.

10. Heizung nach einem der vorstehenden Ansprüche, **dadurch gekennzeichnet, daß** die Klebstoffschicht (15) höchstens 0,15 mm dick ist.

11. Heizung nach einem der vorstehenden Ansprüche, **dadurch gekennzeichnet, daß** zwischen der Metallplatte (7) und der Schaltungsträgerplatte (6) starre Abstandhalter (12) vorgesehen sind, welche einen niedrigen Abstand zwischen der Metallplatte (7) und der Schaltungsträgerplatte (6) gewährleisten.

12. Heizung nach Anspruch 11, **dadurch gekennzeichnet, daß** die Abstandhalter (12) Höcker sind, welche die Metallplatte (7) an Stellen aufweist, welchen auf der Unterseite der Schaltungsträgerplatte (6) keine Leiterbahn (13) gegenüberliegt.

13. Heizung nach Anspruch 11 oder 12, **dadurch gekennzeichnet, daß** die Abstandhalter durch Prägen der Metallplatte (7) gebildet sind.

14. Heizung nach einem der Ansprüche 11 bis 13, **dadurch gekennzeichnet, daß** die Metallplatte (7) mittels eines oder mehrerer der Abstandhalter (12) mit einer Leiterbahn (13) der Schaltungsträgerplatte (6) verbunden ist, welche auf Massepotential liegen soll.

15. Heizung nach einem der vorstehenden Ansprüche, **dadurch gekennzeichnet, daß** die Schaltungsträgerplatte (6) an den Stellen, an welchen die Leistungshalbleiter (5) angeordnet sind, eine hohe Dichte von Strompfaden (9) aufweist, welche von der Oberseite der Schaltungsträgerplatte (6) durch die Schaltungsträgerplatte (6) hindurch bis auf deren Unterseite führen.

16. Heizung nach Anspruch 15, **dadurch gekennzeichnet, daß** die Strompfade (9) mit einem Metall, insbesondere mit Kupfer oder mit Lötzinn, gefüllte Bohrungen sind.

17. Heizung nach Anspruch 15 oder 16, **dadurch gekennzeichnet, daß** die Strompfade eine Metallfläche (20) auf der Oberseite der Schaltungsträgerplatte (6) mit einer Metallfläche (21) auf der Unterseite der Schaltungsträgerplatte (6) verbinden.

18. Heizung nach Anspruch 17, **dadurch gekennzeichnet, daß** die Metallflächen (20, 21) annähernd so groß sind wie die Grundfläche des jeweiligen Leistungshalbleiters (5).

19. Heizung nach einem der vorstehenden Ansprüche, **dadurch gekennzeichnet, daß** der Verbinder (2) lösbar mit der Metallplatte (7) und/oder mit dem bzw. den Kühlkörpem (4a) verbunden ist.

20. Heizung nach Anspruch 19, **dadurch gekennzeichnet, daß** die Verbindung zwischen dem Verbinder (2) und der Metallplatte (7) und/oder den Kühlkörpem (4a) eine Steckverbindung ist.

21. Heizung nach Anspruch 19 oder 20, **dadurch gekennzeichnet, daß** der Verbinder (2) starr ausgebildet ist und vorzugsweise ein Stab oder Hohlstab ist.

22. Heizung nach Anspruch 20 oder 21, **dadurch gekennzeichnet, daß** aus der metallischen Platte (7) einander paarweise gegenüberliegende Zungen (14) ausgeschnitten und aus der Ebene der Metallplatte (7) weggebogen sind, deren gegenseitiger Abstand kleiner ist als die Dicke des starren Verbinders (2), welcher zwischen ein solches Paar Zungen (14) einführbar ist.

23. Heizung nach einem der vorstehenden Ansprüche, **dadurch gekennzeichnet, daß** die Kühlkörper (4a) Bleche sind.

24. Heizung nach einem der vorstehenden Ansprüche, **dadurch gekennzeichnet, daß** die Kühlkörper (4a) die Verbinder (2) miteinander verbinden.

25. Heizung nach Anspruch 24, **dadurch gekennzeichnet, daß** die Kühlkörper (4a) auf die Verbinder (2) aufgeschoben sind.

26. Heizung nach Anspruch 25, **dadurch gekennzeichnet, daß** die Kühlkörper (4a) kraftschlüssig auf den Verbindern (2) gehalten sind.

27. Heizung nach einem der vorstehenden Ansprüche, **dadurch gekennzeichnet, daß** die Heizelemente (3) die von ihnen erzeugte Wärme durch Wärmeabgabeeinrichtungen (4) abgeben, welche bei bestimmungsgemäßem Einbau in ein Kraftfahrzeug in einem Kanal liegen, welcher zur Erwärmung der Fahrgastzelle des Kraftfahrzeuges von Luft durchströmbar ist.

28. Heizung nach Anspruch 27, **dadurch gekennzeichnet, daß** die Kühlkörper (4a) in der Nachbarschaft der Wärmeabgabeeinrichtungen (4) der Heizelemente (3) liegen.

29. Heizung nach Anspruch 28, **dadurch gekennzeichnet, daß** die Kühlkörper (4a) zwischen den Wärmeabgabeeinrichtungen (4) für die Heizelemente (3) und dem Gehäuse (8) mit Abstand vom Gehäuse (8) angeordnet sind.

30. Heizung nach einem der vorstehenden Ansprüche, **dadurch gekennzeichnet, daß** die Heizelemente (3) in Heizstäben enthalten sind, welche zugleich als die Verbinder (2) zwischen der metallischen Platte (7) und den Kühlkörpern (4a) dienen.

31. Heizung nach Anspruch 27 und 30, **dadurch gekennzeichnet, daß** die Wärmeabgabeeinrichtungen (4) und die Kühlkörper (4a) ähnlich oder übereinstimmend ausgebildet sind.

32. Heizung nach Anspruch 30 oder 31, **dadurch gekennzeichnet, daß** die Heizstäbe (2) auf einem an das Gehäuse (8) anschließenden Abschnitt, auf welchem sich die Kühlkörper (4a) befinden, noch keine Heizelemente (3) enthalten.

33. Heizung nach einem der vorstehenden Ansprüche, **dadurch gekennzeichnet, daß** die Verbinder (2) von einer Stelle ausgehen, welche nahe bei den Leistungshalbleitem (5) liegt.

34. Heizung nach einem der vorstehenden Ansprüche, **dadurch gekennzeichnet, daß** der bzw. die spannungführende Zuleitung (16) zu dem bzw. den Heizelementen (3) mittels eines auf der Schaltungsträgerplatte (6) vorgesehenen Steckverbinders (17) mit dem Leistungsausgang des zugehörigen Leistungshalbleiters (5) verbunden ist.

35. Heizung nach Anspruch 30 und 34, **dadurch gekennzeichnet, daß** die Zuleitung (16) starr mit dem Heizstab (2) verbunden ist und die Steckrichtung des Steckverbinders (17) mit der Längsrichtung des Heizstabes (2) übereinstimmt.

36. Heizung nach Anspruch 34 oder 35, **dadurch gekennzeichnet, daß** der Steckverbinder (17) auf der der metallischen Platte (7) abgewandten Seite der Schaltungsträgerplatte (6) angeordnet und durch ein Loch in der Schaltungsträgerplatte hindurch für die Zuleitung (16) zugänglich ist.

## Claims

1. Electric heating system for motor vehicles with the following characteristics:
• The heating system has one or several electric heating elements (3);
• a control circuit is provided for controlling the power dissipated by the heating elements (3),
**characterised in that,**
• the control circuit comprises one or several power semiconductors (5) arranged on a circuit board (6);
• the circuit board (6) is by means of a solid matter connection connected by the side facing away from the power semiconductors (5) (hereinafter referred to as its underside), to a metal plate (7) intended to be lying on ground potential;
• the metal plate (7) is electrically insulated from conductor paths located on the underside of the circuit board (6) and intended to carry a voltage against the ground potential;
• the control circuit is arranged in a housing (8);
• one or several heat sinks (4a) are provided outside the housing (8);
• the metal plate (7), located in the housing (8), is connected with the heat sinks (4a) arranged outside the housing (8) by thermally conductive connectors (2).

2. The heating system as defined in Claim 1, **characterized in that** the metal plate (7) consists of a metal which conducts heat well, especially aluminum or copper, or of alloys of such metals.

3. The heating system as defined in Claim 1 or Claim 2, **characterized in that** the metal plate (7) carries on its surface facing the circuit board (6) a thin, electrically insulating layer, especially a synthetic resin varnish or an oxide layer, which preferably is anodically reinforced.

4. The heating system as defined in any of the preceding claims, **characterized in that** the metal plate (7) is glued to the circuit board (6).

5. The heating system as defined in Claim 4, **characterized in that** the glue layer (15) provided between the metal sheet (7) and the circuit board (6) has a thermal conductivity of at least 0.6 W/(m x K), preferably at least 0.9 W/(m x K).

6. The heating system as defined in Claim 4 or Claim 5, **characterized in that** the glue is a cross-linked two-component silicon elastomer.

7. The heating system as defined in any of the preceding claims, **characterized in that** the metal plate (7) is approximately as big as the circuit board (6).

8. The heating system as defined in any of the preceding claims, **characterized in that** the metal plate (7) has approximately the same contour as the circuit board (6).

9. The heating system as defined in any of the preceding claims, **characterized in that** the glue layer (15) has a thickness of maximally 0.2 mm.

10. The heating system as defined in any of the preceding claims, **characterized in that** the glue layer (15) has a thickness of maximally 0.15 mm.

11. The heating system as defined in any of the preceding claims, **characterized in that** rigid spacers (12) are provided between the metal plate (7) and the circuit board (6), which guarantee a small distance between the metal plate (7) and the circuit board (6).

12. The heating system as defined in Claim 11, **characterized in that** the spacers (12) take the form of bumps provided on the metal plate (7) in areas opposite to the underside of the circuit board (6) where no conductor paths (13) are arranged.

13. The heating system as defined in Claim 11 or Claim 12, **characterized in that** the spacers are formed by embossing of the metal plate (7).

14. The heating system as defined in any of Claims 11 to 13, **characterized in that** the metal plate (7) is connected with one conductor path (13) of the circuit board (6), which is intended to be connected to ground potential, by one or more spacers (12).

15. The heating system as defined in any of the preceding claims, **characterized in that** the circuit board (6) has a high density of electrical current paths (9) in those areas where the power semiconductors (5) are provided, which current paths lead from the upper surface of the circuit board (6) and through the circuit board (6) to its underside.

16. The heating system as defined in Claim 15, **characterized in that** the current paths (9) are inside bores filled with a metal, especially copper or tin-lead solder.

17. The heating system as defined in Claim 15 or Claim 16, **characterized in that** the current paths connect a metal surface (20) on the upper surface of the circuit board (6) with a metal surface (21) on the underside of the circuit board (6).

18. The heating system as defined in Claim 17, **characterized in that** the metal surfaces (20, 21) are approximately as big as the base surface of the respective power semiconductor (5).

19. The heating system as defined in any of the preceding claims, **characterized in that** the connector (2) is detachably connected with the metal plate (7) and/or with the one or more heat sinks (4a).

20. The heating system as defined in Claim 19, **characterized in that** the connection between the connector (2) and the meal plate (7) and/or the heat sinks (4a) is a plug-in connection.

21. The heating system as defined in Claim 19 or Claim 20, **characterized in that** the connector (2) has a rigid configuration and is preferably a rod or a hollow rod.

22. The heating system as defined in Claim 20 or 21, **characterized in that** reeds (14) arranged in pairs one opposite the other, are cut out from the metal plate (7) and are bent off from the plane of the metal plate (7), the distance between such tongues being smaller than the thickness of the rigid connector (2) that can be introduced between any pair of such reeds (14).

23. The heating system as defined in any of the preceding claims, **characterized in that** the heat sinks (4a) are metal sheets.

24. The heating system as defined in any of the preceding claims, **characterized in that** the connectors (2) are interconnected by the heat sinks (4a).

25. The heating system as defined in Claim 24, **characterized in that** the heat sinks (4a) are pushed onto the connectors (2).

26. The heating system as defined in Claim 25, **characterized in that** the heat sinks (4a) are held on the connectors (2) in force-locking engagement.

27. The heating system as defined in any of the preceding claims, **characterized in that** the heating elements (3) dissipate the heat generated by them via heat-dissipating means (4) which, when mounted in a vehicle in the intended way, come to lie in a channel that can be passed by air for the purpose of heating up the passenger compartment of the vehicle.

28. The heating system as defined in Claim 27, **characterized in that** the heat sinks (4a) are positioned in the neighbourhood of the heat-dissipating means (4) of the heating elements (3).

29. The heating system as defined in Claim 28, **characterized in that** the heat sinks (4a) are arranged between the heat-dissipating means (4) for the heating elements (3) and the housing (8), though at a distance from the housing (8).

30. The heating system as defined in any of the preceding claims, **characterized in that** the heating elements (3) are contained in heating rods which simultaneously serve as connectors (2) between the metal sheet (7) and the heat sinks (4a).

31. The heating system as defined in Claims 27 and 28, **characterized in that** the heat-dissipating means (4) and the heat sinks (4a) are designed identically or in a conforming fashion.

32. The heating system as defined in Claim 30 or Claim 31, **characterized in that** the heating rods (2) do not have any heating elements (3) on a section following the housing (8), where the heat sinks (4a) are provided.

33. The heating system as defined in any of the preceding claims, **characterized in that** the connectors (2) extend from an area which is close to the power semiconductors (5).

34. The heating system as defined in any of the preceding claims, **characterized in that** the one or more potential-carrying supply lines (16) to the one or more heating elements (3) is/are connected to the power output of the respective power semiconductor (5) by a plug-in-connector (17) provided on the circuit board (6).

35. The heating system as defined in Claims 30 and 34, **characterized in that** the supply line (16) is rigidly connected with the heating rod (2) and the plug-in direction of the plug-in connector (17) coincides with the longitudinal direction of the heating rod (2).

36. The heating system as defined in Claim 34 or Claim 35, **characterized in that** the plug-in connector (17) is arranged on the surface of the circuit board (6) that faces away from the metal plate (7), and is accessible for the supply line (16) through a hole in the circuit board.

## Revendications

1. Chauffage électrique pour des véhicules automobiles, comprenant les caractéristiques indiquées ci-après :
- le chauffage possède un ou plusieurs éléments de chauffage électrique (3) ;
- pour le réglage de la puissance dégagée par les éléments de chauffage (3), on prévoit un circuit de réglage,
**caractérisé en ce que**
- le circuit de réglage comprend un ou plusieurs semi-conducteurs de puissance (5) qui sont disposés sur une plaque de support (6) du circuit ;
- la plaque de support (6) du circuit est reliée, sur son côté qui se détourne des semi-conducteurs de puissance (5) (que l'on désignera ci-après par l'expression « son côté inférieur »), de manière substantielle à une plaque métallique (7) qui est prévue pour être mise au potentiel de masse ;
- la plaque métallique (7) est isolée par rapport à des pistes conductrices qui se trouvent sur le côté inférieur de la plaque de support (6) du circuit et qui sont prévues pour le guidage d'une tension par rapport au potentiel de masse ;
- le circuit de réglage se trouve dans un logement (8) ;
- à l'extérieur du logement (8), on prévoit un ou plusieurs dissipateurs de chaleur (4a) ;
- des éléments de liaison (2) thermoconducteurs relient la plaque métallique (7) disposée dans le logement (8) aux dissipateurs de chaleur (4) disposés à l'extérieur du logement (8).

2. Chauffage selon la revendication 1, **caractérisé en ce que** la plaque métallique (7) est constituée d'un métal bon conducteur de chaleur, en particulier d'aluminium ou de cuivre ou encore d'alliages de ces métaux.

3. Chauffage selon la revendication 1 ou 2, **caractérisé en ce que** la plaque métallique (7), sur son côté tourné vers la plaque de support (6) du circuit, porte une mince couche procurant une isolation électrique, en particulier une laque de résine synthétique ou une couche d'oxyde qui est renforcée de préférence par voie anodique.

4. Chauffage selon l'une quelconque des revendications précédentes, **caractérisé en ce que** la plaque métallique (7) est collée à la plaque de support (6) du circuit.

5. Chauffage selon la revendication 4, **caractérisé en ce que** la couche de colle (15) prévue entre la plaque métallique (7) et la plaque de support (6) du circuit présente une conductibilité thermique d'au moins 0,6 W/(m x κ), de préférence d'au moins 0,9 W/(m x κ).

6. Chauffage selon la revendication 4 ou 5, **caractérisé en ce que** la colle est un élastomère de silicone réticulable à deux composants.

7. Chauffage selon l'une quelconque des revendications précédentes, **caractérisé en ce que** la dimension de la plaqué métallique (7) est approximativement égale à celle de la plaque de support (6) du circuit.

8. Chauffage selon l'une quelconque des revendications précédentes, **caractérisé en ce que** la forme du contour de la plaque métallique (7) est approximativement égale à celle de la plaque de support (6) du circuit.

9. Chauffage selon l'une quelconque des revendications précédentes, **caractérisé en ce que** l'épaisseur maximale de la couche de colle (15) s'élève à 0,2 mm.

10. Chauffage selon l'une quelconque des revendications précédentes, **caractérisé en ce que** l'épaisseur maximale de la couche de colle (15) s'élève à 0,15 mm.

11. Chauffage selon l'une quelconque des revendications précédentes, **caractérisé en ce qu'**on prévoit, entre la plaque métallique (7) et la plaque de support (6) du circuit, des écarteurs rigides (12) qui garantissent un faible écart entre la plaque métallique (7) et la plaque de support (6) du circuit.

12. Chauffage selon la revendication 11, **caractérisé en ce que** les écarteurs (12) sont des bosses que présente la plaque métallique (7) à des endroits face auxquels, sur le côté inférieur de la plaque de support (6) du circuit, on ne trouve aucune piste conductrice (13).

13. Chauffage selon la revendication 11 ou 12, **caractérisé en ce qu'**on forme les écarteurs par emboutissage de la plaque métallique (7).

14. Chauffage selon l'une quelconque des revendications 11 à 13, **caractérisé en ce que** la plaque métallique (7) est reliée, à l'aide d'un ou de plusieurs écarteurs (12), à une piste conductrice (13) de la plaque de support (6) du circuit, qui doit être mise au potentiel de masse.

15. Chauffage selon l'une quelconque des revendications précédentes, **caractérisé en ce que** la plaque de support (6) du circuit présente, aux endroits auxquels sont disposés les semi-conducteurs de puissance (5), une forte densité de trajets de courant (9) qui s'étendent depuis le côté supérieur de la plaque de support (6) du circuit jusqu'au côté inférieur de cette dernière en traversant la plaque de support (6) du circuit.

16. Chauffage selon la revendication 15, **caractérisé en ce que** les trajets de courant (9) sont des alésages garnis d'un métal, en particulier de cuivre ou d'étain de brasage.

17. Chauffage selon la revendication 15 ou 16, **caractérisé en ce que** les trajets de courant relient une surface métallique (20) sur le côté supérieur de la plaque de support (6) du circuit à une surface métallique (21) sur le côté inférieur de la plaque de support (6) du circuit.

18. Chauffage selon la revendication 17, **caractérisé en ce que** la dimension des surfaces métalliques (20, 21) est approximativement égale à celle de la surface du semi-conducteur de puissance respectif (5).

19. Chauffage selon l'une quelconque des revendications précédentes, **caractérisé en ce que** l'élément de liaison (2) est relié de manière amovible à la plaque métallique (7) et/ou au dissipateur respectivement aux dissipateurs de chaleur (4a).

20. Chauffage selon la revendication 19, **caractérisé en ce que** la liaison entre l'élément de liaison (2) et la plaque métallique (7) et/ou les dissipateurs de chaleur (4a) est une liaison enfichable.

21. Chauffage selon la revendication 19 ou 20, **caractérisé en ce que** l'élément de liaison (2) est réalisé de manière rigide et représente de préférence une barre ou une barre creuse.

22. Chauffage selon la revendication 20 ou 21, **caractérisé en ce que** des languettes (14) opposées les unes aux autres par paires, sont découpées de la plaque métallique (7) et sont pliées en s'écartant du plan de la plaque métallique (7), l'écartement mutuel desdites languettes étant inférieur à l'épaisseur de l'élément de liaison rigide (2) apte à venir s'insérer entre une telle paire de languettes (14) .

23. Chauffage selon l'une quelconque des revendications précédentes, **caractérisé en ce que** les dissipateurs de chaleur (4a) sont des tôles.

24. Chauffage selon l'une quelconque des revendications précédentes, **caractérisé en ce que** les dissipateurs de chaleur (4a) relient les éléments de liaison (2) les uns aux autres.

25. Chauffage selon la revendication 24, **caractérisé en ce qu'**on fait coulisser les dissipateurs de chaleur (4a) sur les éléments de liaison (2).

26. Chauffage selon la revendication 25, **caractérisé en ce que** les dissipateurs de chaleur (4a) sont maintenus par friction sur les éléments de liaison (2).

27. Chauffage selon l'une quelconque des revendications précédentes, **caractérisé en ce que** les éléments de chauffage (3) qui dégagent la chaleur qu'ils génèrent via des mécanismes de dégagement de chaleur (4) qui sont disposés, via un encastrement destiné spécifiquement à un véhicule automobile, dans un canal qui peut être traversé par l'air pour le réchauffement de l'habitacle du véhicule automobile.

28. Chauffage selon la revendication 27, **caractérisé en ce que** les dissipateurs de chaleur (4a) sont disposés à proximité des mécanismes de dégagement de chaleur (4) des éléments de chauffage (3).

29. Chauffage selon la revendication 28, **caractérisé en ce que** les dissipateurs de chaleur (4a) sont disposés entre les mécanismes de dégagement de chaleur (4) pour les éléments de chauffage (3) et le logement (8), à l'écart du logement (8).

30. Chauffage selon l'une quelconque des revendications précédentes, **caractérisé en ce que** les éléments de chauffage (3) sont contenus dans des cartouches chauffantes qui font en même temps office d'éléments de liaison (2) entre la plaque métallique (7) et les dissipateurs de chaleur (4a).

31. Chauffage selon les revendications 27 et 30, **caractérisé en ce que** les mécanismes de dégagement de chaleur (4) et les dissipateurs de chaleur (4a) sont réalisés de manière analogue ou de manière concordante.

32. Chauffage selon la revendication 30 ou 31, **caractérisé en ce que** les cartouches chauffantes (2) sont disposées sur une section se raccordant au logement (8), section sur laquelle on ne trouve, ni des dissipateurs de chaleur (4a), ni des éléments de chauffage (3).

33. Chauffage selon l'une quelconque des revendications précédentes, **caractérisé en ce que** les éléments de liaison (2) partent d'un endroit qui est proche des semi-conducteurs de puissance (5).

34. Chauffage selon l'une quelconque des revendications précédentes, **caractérisé en ce que** l'alimentation, respectivement les alimentations de courant (16) à l'élément, respectivement aux éléments de chauffage (3) est reliée, respectivement sont reliées, à l'aide d'un connecteur enfichable (17) prévu sur la plaque de support (6) du circuit, à la sortie du semi-conducteur respectif (5) .

35. Chauffage selon les revendications 30 et 34, **caractérisé en ce que** l'alimentation (16) est reliée de manière rigide à la cartouche chauffante (2) et la direction d'enfichage du connecteur enfichable (17) coïncide avec la direction longitudinale de la cartouche chauffante (2).

36. Chauffage selon la revendication 34 ou 35, **caractérisé en ce que** le connecteur enfichable (17) est disposé sur le côté de la plaque de support (6) du circuit, qui se détourne de la plaque métallique (7), et est accessible pour l'alimentation (6) via un trou pratiqué à travers la plaque de support de circuit.
